(19) **Europäisches Patentamt**

**European Patent Office**

**Office européen des brevets**

(11) **EP 1 560 269 A1**

(12) **EUROPEAN PATENT APPLICATION**

(43) Date of publication:
**03.08.2005 Bulletin 2005/31**

(51) Int Cl.⁷: **H01L 29/94**, H01L 21/02,
H01L 21/334

(21) Application number: **04360007.1**

(22) Date of filing: **30.01.2004**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (72) Inventor: **Gerhardt, Erwin**<br>**71254 Ditzingen (DE)** |
| (71) Applicant: **ALCATEL**<br>**75008 Paris (FR)** | (74) Representative: **Kohler Schmid Möbus**<br>**Patentanwälte**<br>**Ruppmannstrasse 27**<br>**70565 Stuttgart (DE)** |

(54) **MOS capacitor in an integrated semiconductor circuit**

(57)     This invention relates to a Metal Oxide on Semiconductor (MOS) technology capacitor and an integrated semiconductor circuit comprising a MOS technology capacitor or a Bipolar Complementary Metal Oxide on Semiconductor (BiCMOS) technology capacitor comprising said MOS technology capacitor. The integrated MOS technology capacitor is comprising at least one conducting gate layer 1, preferably a polycrystaline semiconductor layer, at least one insulating layer 2, preferably a metal oxide layer, adjacent to said gate layer 1 and at least one semiconductor layer 3 adjacent to said metal insulating layer 2, wherein at least an area of said semiconductor layer 3 is highly doped.

**Fig. 2**

EP 1 560 269 A1

## Description

This invention relates to a Metal Oxide on Semiconductor (MOS) technology capacitor and an integrated semiconductor circuit comprising a MOS technology capacitor or a Bipolar Complementary Metal Oxide on Semiconductor (BiCMOS) technology capacitor comprising said MOS technology capacitor. The integrated MOS technology capacitor is comprising at least one conducting gate layer, preferably a polycrystaline semiconductor layer, at least one insulating layer, preferably a metal oxide layer, adjacent to said gate layer and at least one semiconductor layer adjacent to said metal insulating layer. The capacitor acccording to the invention preferably is used in Application-Specific Integrated Circuits (ASIC) using MOS, preferably BiCMOS type processes.

Nearly all Integrated circuits use capacitor devices as frequency dependent elements or for blocking purposes. Several demands are made on the electrical performance of these devices. For example, these demands are small area consumption, i.e. high capacitance density; independence on applied voltage, i.e. high linearity; and a small ohmic access resistance, i.e. good radio frequency (rf) performance.

## State of the art

According to prior art there are solutions based on plate capacitors between either two metal or polysilicon layers or a combination of both. Further junction capacitors and MOS-capacitors are well known. Disadvantages of the existing solutions are:

- Metal plate capacitors show good linearity but need very large area size if applied to usual isolation thickness of common metalisation schemes or need additional effort if one applies a special isolation layer.
- Poly plate- or the combination of one poly- and one metal layer- capacitors need smaller areas but they exhibit too large access resistance due to the low-doped poly layer which strongly deteriorate the electrical performance of the capacitor.
- Junction capacitances show relatively high capacitance densities but strongly depend on there operating point. This disadvantage results in complicated installation procedures and high installation costs.

It is therefore an object of the invention to provide an integrated MOS or BiCMOS technology capacitor which overcomes the problems associated with the related art, in particular which capacitor shows linear behavior of its electric properties and which can be produced without applying additional production steps to MOS or BiCMOS production technology. Furthermore, it is an object of the invention to provide a method for producing the inventive integrated capacitor.

## Object of the invention

The object concerning an integrated capacitor is attained by the capacitors according to claim 1 and/ or claim 6. The object concerning the method for producing an inventive capacitor is attained by the method defined in claim 10. Further advantageous features of the invention are defined in the depending claims.

## Short description of the invention

The inventive integrated MOS technology capacitor is comprising at least one conducting gate layer, preferably a polycrystaline semiconductor layer, at least one insulating layer, preferably a metal oxide layer, adjacent to said gate layer and at least one semiconductor layer adjacent to said metal insulating layer.

According to the invention, at least an area of said semiconductor layer is highly doped. The semiconductor layer should be doped as high as possible. The higher the semiconductor layer is doped the better linear behavior of its electric properties can be achieved. The doping should be at least as high as $10^{18}$ per cubic centimeter. The gate layer may be a polycrystalline (poly-) silicon layer.

The inventive integrated MOS technology capacitor provides at least in the following advantages:

- The inventive integrated MOS technology capacitor has a high capacitance density, a high linearity of its electric properties and a low access resistivity.
- The area size per required capacitance value is reduced by a factor of about ten compared to capacitors according to prior art.
- The maximum voltage that can be applied always exceeds that of the underlying MOS devices, thus that of the usual circuit supply voltage.
- Due to the low-ohmic access resistance, rf performance is superior compared to known junction capacitors.
- Leakage currents are low.
- The inventive capacitor can be produced without additional production steps to MOS technology production, resulting in that no additional processing costs are needed.
- As the chip area that has to be spent for such capacitors is expensive and increases effective defect density, chips can be made smaller and/or cheaper
- The access resistance of the inventive capacitor is lower than that of known integrated capacitors except that of a pure metal-metal capacitor.
- The parasitic capacitance to the rf ground-substrate of an integrated circuit comprising the inventive capacitor is only small.

Preferably, said insulating layer is a high-k layer. The insulating layer of a MOS capacitor usually is a silicon-oxide ($SiO_2$) layer. A high-k layer has a higher dielectric constant $\varepsilon$ than a $SiO_2$ layer. The dielectric constant $\varepsilon$ of a high-k layer has a value higher or equal to four. The high-k layer for example is a tantalum-nitrogen (TaN) layer. Thus, the capacitance density of the capacitor is increased by a factor C, which is a function of $\varepsilon$

Preferably, said gate layer is a metal sheet layer. If the gate layer is a metal sheet layer, e.g. made of aluminum (Al) or copper (Cu) instead of poly-silicon, the access resistivity of the inventive capacitor can be reduced by a factor 20 to 50 relatively to the access resistivity of the inventive capacitor having a poly-silicon gate layer.

Preferably, said highly doped semiconductor layer is doped in a maximum scale of $10^{24}$ per cubic centimeter. This results in an effective doping in a scale of about $10^{20}$ per cubic centimeter. The doping should be as high as possible to decrease voltage dependency of the capacitors electrical properties .

Preferably, the doping of the highly doped semiconductor layer is a N-type doping. The inventive capacitor also can be P-type doped. N-Type doping has the advantage that the scale of the doping can be higher than in the case of P-Type doping, because of e.g. a lower electronic activation energy of N-Type energy levels and/or high diffusion of P-Type doping.

In another embodiment of the invention an integrated BiCMOS technology capacitor is provided. The inventive integrated BiCMOS technology capacitor is comprising an integrated MOS technology capacitor according to the invention and a buried layer adjacent to said semiconductor layer and a sink layer, having a low-ohmic contact to said buried layer. The buried layer and the sink layer may be N+ doped for example. The sink layer is a low-ohmic vertical connection to the buried layer. The inventive integrated BiCMOS technology capacitor provides the advantages of the inventive integrated MOS technology capacitor. Furthermore, the access resistance can be decreased and the linearity of the electronic properties can be increased by the inventive BiCMOS capacitor relatively to the inventive MOS capacitor.

Preferably, said buried layer is comprising a metal sheet layer. If the buried layer is a metal sheet layer, e.g. made of aluminum (Al) or copper (Cu), instead of a semiconductor material, the access resistivity of the inventive capacitor can be reduced by a factor 20 to 50 relatively to the access resistivity of the inventive capacitor having a semiconductor material buried layer.

In another embodiment of the invention, an integrated semiconductor circuit, comprising an integrated BiCMOS technology capacitor according to the invention and other circuit elements, is provided. Instead of a BiCMOS technology capacitor also a CMOS technology capacitor can be used, if the integrated semiconductor circuit is fabricated using only CMOS technology. The integrated BiCMOS technology capacitor is connected to the other circuit elements at a first node, being said gate layer and a second node, being the combination of said collector and said sink layer. This inventive integrated semiconductor circuit makes the advantages of the inventive BiCMOS technology capacitor available to any integrated circuit.

The integrated semiconductor circuit is comprising an integrated MOS technology capacitor according to the invention. This inventive integrated semiconductor circuit makes the advantages of the inventive MOS technology capacitor available to any integrated circuit.

In another embodiment of the invention, a method for producing an integrated MOS technology capacitor according to the invention is provided. The inventive method is comprising the steps of a MOS process, wherein at least an area of a semiconductor layer is highly doped and at least one insulating layer is processed adjacent to said semiconductor layer and a gate layer is processed adjacent to said insulating layer. The inventive production method consists of a novel, intelligent combination of already existing layers and/or processing steps of MOS and/or BiCMOS processes. A BiCMOS process is a manufacturing process for semiconductor devices that offers both, bipolar and Complementary Metal oxide on Semiconductor (CMOS) devices to provide designers with the largest menu of available devices.
By applying the inventive production method, steps used for doping sheets of other elements of an integrated circuit can be used for processing the highly doped area of the inventive capacitor. In case of a BiCMOS process, i.e. the process steps for producing a bipolar transistor, often having highly N- or P-doped, e.g. B type doped, areas and always having highly doped buried layers, and comprising the process steps to produce a MOS transistor, comprising a thin $SiO_2$ gate oxide producing step to produce a plate capacity part, the high doping of the semiconductor layer according to the invention can be reached with existing process steps. In case of a pure MOS process- , wherein mostly there is no buried layer processing step, the doping of the semiconductor layer should be increased by an additional optimizing processing step. Otherwise the properties of the inventive capacitor are not optimal. Doped means adding a dopant to a semiconductor. A dopant is an impurity added to a semiconductor to change the number of holes and electrons relative to each other. Common usage is to speak about "N doped", i.e. using dopants to increase electrons/negative charges in the semiconductor area. Boron [B] is the most commonly used "P-type" dopant and has a relatively high diffusivity compared to e.g. arsenic[As] a common N-type dopant, and a diffusivity similar to phosphorus [P], another common N-type dopant. "B type doped" means doped with boron.

The different features of the preferred embodiments of the invention may be used in combination together with the invention as set forth in the independent claims or just each single preferred embodiment together with the invention as set forth in the independent claims.

The embodiments of the invention will now be described with reference to the accompanying drawings.

In fig. 1 a sketch of an integrated MOS technology capacitor according to the invention is shown.
In fig. 2 a sketch of an integrated BiCMOS technology capacitor according to the invention is shown.

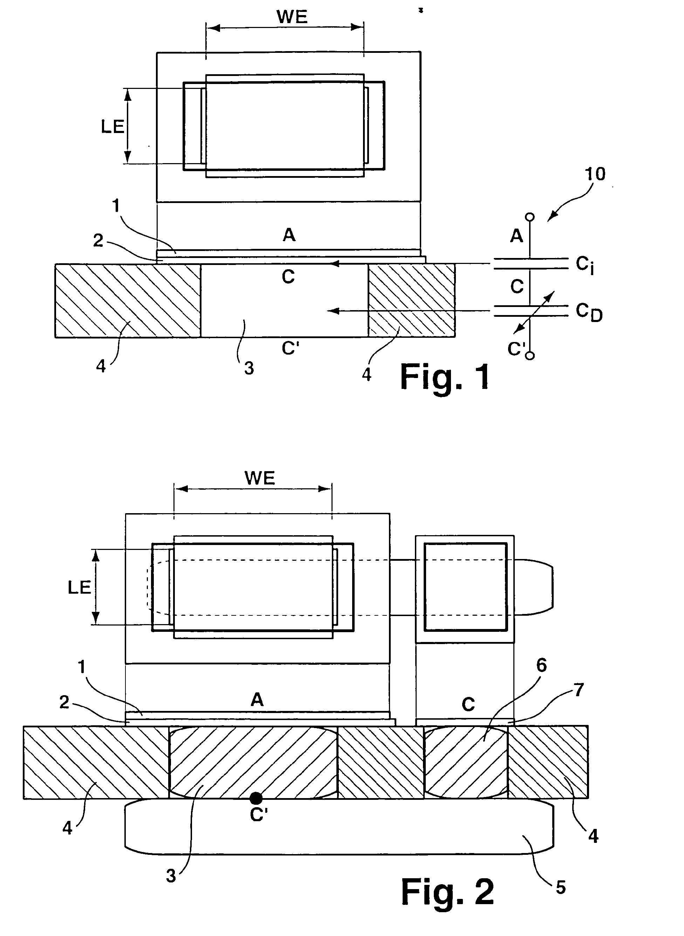

In fig. 1 an integrated MOS technology capacitor according to the invention is shown. The inventive linear capacitor is combining existing process layers to an improved device in comparison to a standard MOS capacitor. The upper part of the figure shows the inventive capacitor in a view as it appears on the surface of a wafer, whereas the lower part of the figure is showing a cross sectional view of the inventive MOS capacitor. The inventive MOS capacitor can be part of an integrated semiconductor circuit in MOS technology, where a capacity is realized basically by means of a metal oxide layer. The inventive integrated MOS technology capacitor is comprising at least one conducting gate layer 1, preferably a polycrystaline semiconductor layer, at least one insulating layer 2, preferably a metal oxide layer, adjacent to said gate layer and at least one semiconductor layer 3 adjacent to said metal insulating layer 2. At least an area of said semiconductor layer 3 is highly doped, i.e. the area below the metal oxide layer 2 is highly doped. The semiconductor layer 3 is building a well. It is positioned in between field oxide layer areas 4.

Analysis showed that the capacitance density of a MOS capacitance is high because of the thin oxide below the gate. This capacitance is undesirably strongly modulated by the applied circuit voltages and the gate polycrystalline layer is low doped resulting in high access resistance. By combining basically a MOS capacitor with additionally doped layers a strongly improved characteristic can be achieved.

The values "WE" and "LE" of the chip area occupied by the capacitor depict the intrinsic part of the capacitance. The inventive capacitor between the nodes marked A and C', i.e. connecting points to other elements of an integrated circuit, comprises a low-ohmic, i.e. highly doped path to the intrinsic capacitance node C.

The total capacitance $C_{total}$ of the MOS capacitor as shown can be calculated as a series combination by

$$C_{total} = \frac{C_i * C_D}{C_i + C_D}$$

wherein $C_i$ is an insulator capacitance between nodes A and C' and $C_D$ is a depletion capacitance between nodes C' and C. A circuit diagram 10 of the different parts of the capacitances of the MOS capacitor is shown in the figure too .

For a given oxide thickness, the value $C_i$ of the insulator capacitance is constant. The semiconductor depletion capacitance $C_D$ is a complicated function of the process architecture features. Important in this context is the fact that this capacitance value is variable with applied voltage. Its sensibility depends on the doping of the semiconductor region below the oxide. By increasing the doping of the segment space between C' and C to very high values no depletion layer appears any more resulting in a plate type capacitor with the high capacitance density of the baseline MOS capacitor without its drawbacks.

In fig. 2 an integrated BiCMOS technology capacitor according to the invention is shown. The upper part of the figure shows the inventive capacitor in a view as it appears on the surface of a wafer, whereas the lower part of the figur is showing a cross sectional view of the inventive BiCMOS capacitor. The inventive integrated BiCMOS technology capacitor is comprising an integrated MOS technology capacitor according to the invention, comprising a conducting gate layer 1, an insulating layer 2 (gate oxide) and a highly doped semiconductor layer 3 and a buried layer 5 adjacent to said semiconductor layer 3 and a sink layer 6 (reach-through), having a low-ohmic contact to said buried layer 5. The sink layer 6 is a low-ohmic vertical connection to the buried layer 5. Because the doping of the reach-through 6, having a high doping level, is applied to the semiconductor layer area 3 below the gate oxide 2, the resulting device does not show the voltage dependency of the originating device, i.e. a BiCMOS device according to prior art, anymore, i.e. the voltage dependency of MOS-capacitors result from the natural serial combination of the gate-oxide of a constant plate capacitor and a junction capacitance of the well itself that will be modulated by applied voltages. The high doping applied according to the invention, fully prevents this effect by cutting off the movements of charges in this region.

One node, marked A, of the inventive BiCMOS capacitor is a polycrystalline layer 1 with the MOS-gate-oxide 2 below it. A second node, marked C, is the collector node of a bipolar device. The collector polycrystalline layer 7, the reach-though 6 and the buried layer 5 are building a bottom node C', all are doped high, i.e. exhibit low access resistance. The bottom node C' is buried in the wafer. It is just a symbolic connection, marked for the purpose of explaining the underlying principle of how the capacity of the whole device can be explained and to show parallels to the MOS-capacitor as shown in fig. 1. The capacity of the BiCMOS capacitor as shown, ideally, if the doping of the semiconductor layer 3 is high enough, is equal to an insulator capacitance $C_i$, which is the intrinsic part of the capacitance of the BiCMOS capacitor without high doping, defined by the values "WE" and "LE" of the chip area occupied by the capacitor.

Existing BiCMOS and/or MOS processes are providing at least two different values for the thickness of a gate-oxide layer. According to this thickness integrated capacitors with different capacity densities and thus different electrical strength can be generated.

Preferably, the polycrystalline layers as well as the monocrystalline layers, e.g. the sink layer 6, should be doped as high as possible. The polycrystalline layers, meaning the gate layers, should be highly doped to have a low ohmic resistance. The monocrystalline layer below the gate-oxide layer is the region having an undesired voltage dependent capacity. This layer should be highly doped to reach an ohmic behavior and thus to suppress the effect of voltage dependency.

**Claims**

1. Integrated MOS technology capacitor, comprising

   - at least one conducting gate layer (1), preferably a polycrystaline semiconductor layer,
   - at least one insulating layer (2), preferably a metal oxide layer, adjacent to said gate layer (1) and
   - at least one semiconductor layer (3) adjacent to said metal insulating layer (2),

   **characterised in that**
   at least an area of said semiconductor layer (3) is highly doped.

2. The integrated MOS technology capacitor according to claim 1,
   **characterised in that** said insulating layer is a high-k layer.

3. The integrated MOS technology capacitor according to claim 1,
   **characterised in that** said gate layer is a metal sheet layer.

4. The integrated MOS technology capacitor according to claim 1,
   **characterised in that** said highly doped semiconductor layer is doped in a maximum scale of $10^{24}$ per cubic centimetre.

5. The integrated MOS technology capacitor according to claim 1,
   **characterised in that** the doping of the highly doped semiconductor layer is a N-type doping.

6. Integrated BiCMOS technology capacitor,
   **characterised in that** the BiCMOS technology capacitor is comprising an integrated MOS technology capacitor according to claim 1 and a buried layer adjacent to said semiconductor layer and a sink layer, having a low-ohmic contact to said buried layer.

7. Integrated BiCMOS technology capacitor according to claim 6,
   **characterised in that** said buried layer is comprising a metal sheet layer.

8. Integrated semiconductor circuit, comprising an integrated BiCMOS technology capacitor according to claim 6 and other circuit elements, wherein the integrated BiCMOS technology capacitor is connected to the other circuit elements at a first node, being said gate layer and a second node, being said collector and/or said sink layer.

9. Integrated semiconductor circuit, comprising an integrated MOS technology capacitor according to claim 1.

10. Method for producing an integrated MOS technology capacitor according to claim 1, comprising the steps of a MOS process, wherein at least an area of a semiconductor layer is highly doped and at least one insulating layer is processed adjacent to said semiconductor layer and a gate layer is processed adjacent to said insulating layer.

Fig. 1

Fig. 2

**EP 1 560 269 A1**

**European Patent Office**

## EUROPEAN SEARCH REPORT

Application Number

EP 04 36 0007

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 046 868 A (IBM) 10 March 1982 (1982-03-10) | 1-5,8-10 | H01L29/94 H01L21/02 H01L21/334 |
| A | * page 3, line 27 - page 5, line 12; figure 3 * | 6,7 | |
| | ----- | | |
| X | US 5 643 820 A (CORNELL MICHAEL E  ET AL) 1 July 1997 (1997-07-01) | 1,4,8-10 | |
| Y | * column 26, line 1 - column 27, line 22; figure 31 * | 6 | |
| | ----- | | |
| X | US 6 627 954 B1 (SEEFELDT JAMES D) 30 September 2003 (2003-09-30) | 1,4,5,9,10 | |
| Y | * column 5, lines 60-65; figure 4 * * column 7, lines 9-60 * | 6,8 | |
| | ----- | | |
| Y | US 6 573 588 B1 (OKUDA TAKASHI  ET AL) 3 June 2003 (2003-06-03) * column 6, lines 25-53; figure 4 * | 6 | |
| | ----- | | |
| X | US 4 285 001 A (GERZBERG LEVY ET AL) 18 August 1981 (1981-08-18) | 1,9,10 | TECHNICAL FIELDS SEARCHED (Int.Cl.7) |
| Y | * the whole document * | 8 | H01L |
| | ----- | | |
| X | US 4 377 029 A (OZAWA OSAMU) 22 March 1983 (1983-03-22) | 1,9,10 | |
| Y | * the whole document * | 8 | |
| | ----- | | |
| X | US 5 360 989 A (ENDO KOICHI) 1 November 1994 (1994-11-01) * the whole document * | 1,9,10 | |
| | ----- | | |
| A | EP 1 372 187 A (MATSUSHITA ELECTRIC IND CO LTD) 17 December 2003 (2003-12-17) * the whole document * | 7 | |
| | ----- | | |

The present search report has been drawn up for all claims

| Place of search | Date of completion of the search | Examiner |
|---|---|---|
| Munich | 1 September 2004 | Blackley, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

7

## ANNEX TO THE EUROPEAN SEARCH REPORT
## ON EUROPEAN PATENT APPLICATION NO.

EP 04 36 0007

This annex lists the patent family members relating to the patent documents cited in the above-mentioned European search report.
The members are as contained in the European Patent Office EDP file on
The European Patent Office is in no way liable for these particulars which are merely given for the purpose of information.

01-09-2004

| Patent document cited in search report | | Publication date | Patent family member(s) | | Publication date |
|---|---|---|---|---|---|
| EP 0046868 | A | 10-03-1982 | CA | 1159917 A1 | 03-01-1984 |
| | | | EP | 0046868 A2 | 10-03-1982 |
| | | | JP | 1499656 C | 29-05-1989 |
| | | | JP | 57045968 A | 16-03-1982 |
| | | | JP | 63049907 B | 06-10-1988 |
| US 5643820 | A | 01-07-1997 | US | 5559044 A | 24-09-1996 |
| | | | US | 5426328 A | 20-06-1995 |
| | | | EP | 0708482 A2 | 24-04-1996 |
| | | | JP | 2947741 B2 | 13-09-1999 |
| | | | JP | 8227945 A | 03-09-1996 |
| | | | US | 5541125 A | 30-07-1996 |
| | | | US | 5618743 A | 08-04-1997 |
| | | | US | 5541123 A | 30-07-1996 |
| | | | US | 5583061 A | 10-12-1996 |
| | | | US | 5547880 A | 20-08-1996 |
| | | | US | 5648281 A | 15-07-1997 |
| | | | DE | 69332097 D1 | 14-08-2002 |
| | | | DE | 69332097 T2 | 19-12-2002 |
| | | | DE | 69332753 D1 | 10-04-2003 |
| | | | DE | 69332753 T2 | 21-08-2003 |
| | | | DE | 69332847 D1 | 08-05-2003 |
| | | | DE | 69332847 T2 | 13-11-2003 |
| | | | EP | 1119051 A1 | 25-07-2001 |
| | | | EP | 1119036 A1 | 25-07-2001 |
| | | | EP | 1119043 A2 | 25-07-2001 |
| | | | EP | 1119044 A1 | 25-07-2001 |
| | | | EP | 1119050 A1 | 25-07-2001 |
| | | | EP | 0589675 A2 | 30-03-1994 |
| | | | JP | 7007094 A | 10-01-1995 |
| | | | JP | 2004072077 A | 04-03-2004 |
| | | | US | 5422508 A | 06-06-1995 |
| | | | US | 5374569 A | 20-12-1994 |
| | | | US | 5416039 A | 16-05-1995 |
| | | | US | 5751054 A | 12-05-1998 |
| US 6627954 | B1 | 30-09-2003 | AU | 3900800 A | 09-10-2000 |
| | | | WO | 0057484 A1 | 28-09-2000 |
| US 6573588 | B1 | 03-06-2003 | JP | 2003332447 A | 21-11-2003 |
| US 4285001 | A | 18-08-1981 | CA | 1128672 A1 | 27-07-1982 |
| | | | DE | 2966634 D1 | 08-03-1984 |
| | | | EP | 0013173 A2 | 09-07-1980 |
| | | | EP | 0051902 A1 | 19-05-1982 |
| | | | JP | 55091154 A | 10-07-1980 |

**ANNEX TO THE EUROPEAN SEARCH REPORT
ON EUROPEAN PATENT APPLICATION NO.**                    EP 04 36 0007

This annex lists the patent family members relating to the patent documents cited in the above-mentioned European search report.
The members are as contained in the European Patent Office EDP file on
The European Patent Office is in no way liable for these particulars which are merely given for the purpose of information.

01-09-2004

| Patent document cited in search report | | Publication date | Patent family member(s) | | Publication date |
|---|---|---|---|---|---|
| US 4377029 | A | 22-03-1983 | JP | 56085848 A | 13-07-1981 |
| | | | DE | 3069529 D1 | 29-11-1984 |
| | | | EP | 0031107 A1 | 01-07-1981 |
| US 5360989 | A | 01-11-1994 | JP | 2740038 B2 | 15-04-1998 |
| | | | JP | 4049651 A | 19-02-1992 |
| | | | EP | 0464453 A1 | 08-01-1992 |
| | | | KR | 9509891 B1 | 01-09-1995 |
| EP 1372187 | A | 17-12-2003 | CN | 1469440 A | 21-01-2004 |
| | | | EP | 1372187 A1 | 17-12-2003 |
| | | | JP | 2004072079 A | 04-03-2004 |
| | | | US | 2003228734 A1 | 11-12-2003 |

EPO FORM P0459